# EUROPEAN PATENT APPLICATION

(11) **EP 4 346 346 A1**
(43) Date of publication of application: **03.04.2024**
(21) Application number: 23194335.8
(22) Date of filing: 30.08.2023
(51) Int. Cl.: H05K 13/02

(54) **TRANSFER SYSTEM**

(30) Priority: 09.09.2022 DE 102022122895
(71) Applicant: ASMPT GmbH & Co. KG, 81379 Munich (DE)
(72) Inventor: FISCHER, Christoph, 82538 Geretsried (DE); JUSTINGER, Johannes, 86899 Landsberg am Lech (DE); PFEIFER, Vincent, 80333 Munich (DE)
(74) Representative: Emerson, Peter James

(57) **Abstract**

A transfer system for transferring items between a vehicle and a receptacle of a machine, comprises a vehicle-side positioning dock mounted to the vehicle, an engagement actuator, and a storage unit for storing at least one item, the storage unit being movably mounted on the vehicle, and including a front face that is adapted to lie adjacent to the receptacle, a vehicle-side positioning member and a machine-side positioning member, and the engagement actuator is operative to move the storage unit between a retracted position in which the vehicle-side positioning member engages with the vehicle-side positioning dock to position the storage unit relative to the vehicle, and a transfer position in which the machine-side positioning member may engage with a machine-side positioning dock located proximate the receptacle to position the storage unit relative to the machine.

## Description

This invention relates to a transfer system for transferring items between a vehicle and a receptacle of a machine, an automatic-guided vehicle and a method of transferring an item from a vehicle to a receptacle of a machine.

### Background and Prior Art

The present invention relates in general to the technical field of equipping component carriers, such as printed circuit boards (PCBs), substrates or workpieces, with electronic components in a so-called surface-mount technology (SMT) process.

The production of such electronic subassemblies occurs typically with so-called placement machines, by which electronic components are removed from a component supply device in an automated manner and placed on a component carrier such as, for example, a printed circuit board. A transfer of components from the component supply device to their respective placement position occurs by means of a component handling device, for example a so-called placement head.

The most common packaging for small electronic components uses carrier tapes, sometimes referred to as "belts", into which small pockets are formed. In each of the pockets there is provided one component. Only one type of component is located within each carrier tape. To save space and for easier transport, the carrier tapes are conventionally formed as reels by winding on a spool. Typically, the tape reel is placed in a feeder module which includes drive means for driving the tape forward, such as a motor-driven pin-wheel which engages with holes provided along the length of the carrier tape, and a pick-up area orwindow which provides access to the components. The feeder module can be removably inserted into a placement machine.

More recently, a cartridge system has been proposed, in which a reel is placed in a passive cartridge module or cassette, which may conveniently be a relatively inexpensive plastic container or envelope of defined shape which may be easily held by a robot, which may be loaded at a central filling station and subsequently inserted into a feeder. As an alternative, if the placement machine itself is provided with tape driving mechanisms, then the cartridge module could be directly inserted into the placement machine. An example of a cartridge and feeder arrangement is described for example in DE 10 2019 127 299.8. In such systems, the feeder unit may be used to drive the carrier tape located within a cartridge unit so that components located within pockets of the carrier tape are moved to a picking region where a placement head of a placement machine can access the components. The picking region could be located within the cartridge or within the feeder, depending on the particular design.

For the operation of the placement machine it is necessary to be able to supply feeders (and / or cartridges depending on the set-up), including respective carrier tapes, to the placement machine. While the feeding of components is largely continuous during operation at high throughput rates, as is the case in smartphone production for example, other electronics manufacturing processes may be characterized by frequent set-up changes, requiring feeders and / or cartridges to be swapped or replaced in bulk. For the purposes of the present specification, the term "set-up change" is to be understood to mean a bulk change in the feeders or cartridges engaged with a placement machine. This is to be contrasted with "replenishment changes" in which feeders and / or cartridges are replaced at the placement machine as they run out, or approach running out, of components, to ensure as uninterrupted a supply of components as possible.

The refilling of material (i.e. carrier tapes) at the line, as well as the retooling (i.e. fitting of different feeders / cartridges) are currently manual processes that require a high level of personnel input. For some years now, considerable efforts have been made to automate material replenishment and changeover.

As specific background art may be mentioned EP3419402A1. As described in this document, an external exchanging device may be provided to transfer a feeder, which includes both feeding capability and material storage, between a storage location and an operational location, with the exchanging device operable to move along a production line with one or more placement machines parallel to the direction of workpiece throughput. The exchanging device is operative to translate along a rail mounted along the production line, and is supported by the rail (for this reason the device may be termed a "rail-guided vehicle"). Such an approach has various advantages, for example using a machine-mounted rail avoids any problems that may arise due to imperfections in the floor surface, since the exchanging device is held at a fixed vertical position relative to the placement machines, and furthermore a high level of positioning accuracy along the production line is possible. However, there are also various disadvantages associated with such a system. For example, it is necessary to use a dedicated exchanging device for each side of the production line, which may limit how close adjacent lines may be placed. The described system also lacks flexibility, and for example cannot manage cartridge-based feeding systems. It has been found that the system is relatively slow, and is also expensive due to the large requirement for dedicated equipment for each production line.

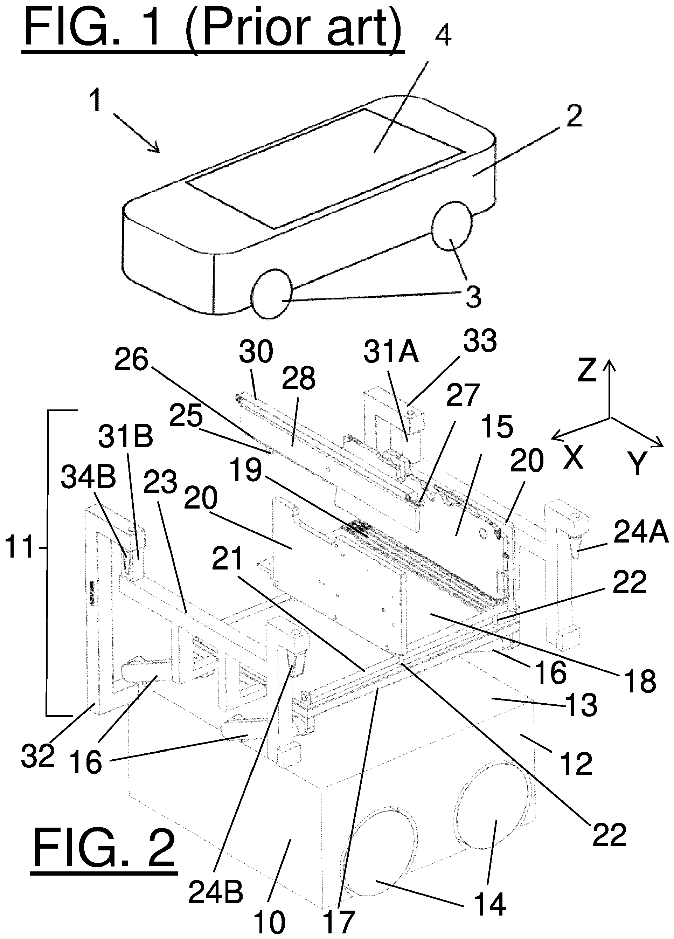

It has been recognised that a more flexible and potentially cheaper solution may be to equip an automatic-guided vehicle (AGV) with a feeder / cartridge replacement mechanism. As is well-known in the art per se, AGVs are small mobile robot devices, typically movable across a floor by means of a wheeled chassis, with at least a degree of autonomy. AGVs are available from many manufacturers (and hence relatively inexpensive and with a likelihood that a production line operator may already possess suitable AGVs), and are typically provided with an upper platform which can carry job-specific equipment. A conventional AGV 1 is schematically shown in FIG. 1, with the chassis 2, wheels 3 and platform 3 highlighted. Unfortunately, the use of AGVs for feeder / cartridge changeover is problematic, since the positioning accuracy of AGVs is generally below that required for feeder / cartridge changeover at a placement machine. If additional means for improving the accuracy are provided, these generally add to the time taken for proper positioning, resulting in unacceptable delays.

The present invention seeks to provide a cost-effective, robust and fast transfer system suitable to enable automatic provision of feeders / cartridges, which can for example be implemented using commercially available AGVs (although may also be usable with custom-made AGVs or even rail-guided vehicles), which is able to effect either or both of set-up changes and replenishment changes. In accordance with the present invention, this aim is achieved by using a mechanical positioning system associated with a storage, such as a feeder / cartridge storage, mountable on an AGV platform.

For convenience, the following terms will be used hereafter in this document with the following meanings:
"Feeder" will be taken to encompass both feeders which include tape reel storage and a driving means for advancing the carrier tape, and modular cartridge - feeder systems in which tape reel storage and driving means are located in separate interengaging cartridge and feeder parts;
X, Y and Z axes will be used as is conventional in the art, with:
   the X axis parallel to the direction of workpiece transport along a production line, increasing in the downstream direction and being substantially horizontal,
   the Y axis orthogonal to the X axis, increasing in the direction towards the placement machine and being substantially horizontal, and
   the Z axis orthogonal to the X and Y axes, being generally vertical and increasing in the upwards direction.

### Summary of the Invention

In accordance with a first aspect of the present invention there is provided a
transfer system for transferring items between a vehicle and a receptacle of a machine, comprising:
an engagement actuator, and
a storage unit for storing at least one item in use, the storage unit being movably mounted on the vehicle in use, wherein the storage unit comprises a front face that is adapted to lie adjacent to the receptacle in use, and a machine-side positioning member,
and wherein the engagement actuator is operative to move the storage unit between a retracted position in which the storage unit is located at a first, relatively close location relative to the vehicle, and a transfer position in which the storage unit is located at a second, relatively far location relative to the vehicle and in which the machine-side positioning member may engage with a machine-side positioning dock located proximate the receptacle to position the storage unit relative to the machine.

In accordance with a second aspect of the present invention there is provided an automatic-guided vehicle comprising the transfer system of the first aspect.

In accordance with a third aspect of the present invention there is provided a method of transferring an item from a vehicle to a receptacle of a machine, comprising the steps of:
i) providing a machine-side positioning dock located proximate the receptacle,
ii) providing a vehicle with the transfer system of the first aspect, with at least one item located within the storage unit,
iii) moving the vehicle proximate the machine, with the storage unit in its retracted position,
iv) moving the storage unit to its transfer position so that the machine-side positioning member engages with the machine-side positioning dock, and
v) transferring the item from the storage unit to the receptacle.

Other specific aspects and features of the present invention are set out in the accompanying claims.

### Brief Description of the Drawings

The invention will now be described with reference to the accompanying drawings (not to scale), in which:
FIG. 1 schematically shows in perspective view a conventional AGV;
FIG. 2 schematically shows in perspective view an AGV fitted with a transfer system in accordance with the present invention, with various parts omitted for clarity;
FIG. 3 schematically shows, in perspective view, a machine-side receptacle;
FIGs. 4 to 9 schematically show, in perspective view, a transfer sequence for feeder replenishment using the AGV and transfer system of FIG. 2;
FIGs. 10 to 12 schematically show, in perspective view, a transfer sequence for a set-up change; and
FIG. 13 schematically shows, in perspective view, a transfer system in accordance with another embodiment of the present invention.

### Detailed Description of the Preferred Embodiments of the Invention

An embodiment of the present invention will now be described with reference to FIG. 2, which schematically shows in perspective view an AGV 10, fitted with a transfer system 11 in accordance with the present invention, with various parts omitted for clarity. In more detail, the transfer system 11 shown is adapted to perform replenishment changes, involving the replacement of items, i.e. feeders in this embodiment, on an ad hoc basis. In FIG. 2, the transfer system 11 is shown with its storage unit (replenishment feeder storage unit 18, as described below) in a retracted position, in which the AGV 10 may safely travel around a facility. The AGV 10 and transfer system 11 may be controlled by an overarching control system (not shown) which controls the placement process. The control system, comprising suitably programmed computing or processing means, may be located at the production line including the placement machine or separately thereto, optionally the control system many be distributed between various local and remote locations. In any case, the AGV 10 and transfer system 11 may communicate with the control system wirelessly as is well-known in the art per se.

The AGV 10 is of a generally standard form, having a chassis 12 which supports a flat platform 13 thereon. Wheels 14 enable to the AGV 10 to move along the ground, preferably these are castor-type wheels which are capable of 360° rotation about respective vertical axes, so that the AGV 10 may travel along the ground in any horizontal direction, and thus able to directly approach a machine (not shown). Indicia (not shown) may be provided at one end of the AGV 10 to identify a notional "front-end" of the AGV 10, for the safety of human operators (not shown) in the vicinity of the machine and AGV 10. For consistency, throughout this specification, the front-back direction of the AGV 10, when it is located next to a machine in preparation for or during transfer, will be denoted as the X direction, the Z axis is vertical, and the Y axis, which is parallel to the lateral side - lateral side direction of AGV 10, increases towards the machine. These axes are shown in FIG. 2.

In use, the transfer system 11 is mounted onto the platform 13, for travel with the AGV 10. In more detail, an engagement actuator comprising a plurality, here four, of pivotable legs 16 is fixedly mounted to the platform 13, so that each pivotable leg 16 is fastened at one end thereof to the platform 13, while being able to pivot about a respective horizontal axis parallel to the X axis. In FIG. 2, only three of the pivotable legs 16 are visible. The engagement actuator also includes a motor (not shown) which is operative to pivot the pivotable legs 16 about their respective pivot axes.

The distal end of each pivotable leg 16 is pivotably connected to a table 17, which provides a flat surface for supporting a replenishment feeder storage unit 18. The replenishment feeder storage unit 18 takes the form of a tray which is adapted to retain at least two feeders 15 (only one feeder 15 being shown for clarity), the feeders 15 being positioned side-by-side in an upright configuration through the provision of feeder engagement tracks 19 at the base of the replenishment feeder storage unit 18. It should be noted that for clarity, only some of the feeder engagement tracks 19 are shown. The feeder engagement tracks 19 are engageable with respective feeders 15, while permitting movement of the respective feeder 15 relative thereto, in a direction parallel to the Y axis shown. Space for a least two feeders is required so that both a replacement feeder full of components and the empty feeder it is replacing can be stored therein. The replenishment feeder storage unit 18 is defined at its front-back extent, i.e. along the X axis, by a pair of sidewalls 20. The replenishment feeder storage unit 18 is movably mounted to the table 17, drivable by a linear actuation system in a direction parallel to the front face of the transfer system, i.e. parallel to the X axis. The linear actuation system shown comprises a worm screw 21 which is mounted to the table 17 extending in the X direction and which engages with gears 22 mounted to the replenishment feeder storage unit 18. An actuator (not shown) may act to rotate the worm screw 21 and thus move the replenishment feeder storage unit 18 parallel to the X axis.

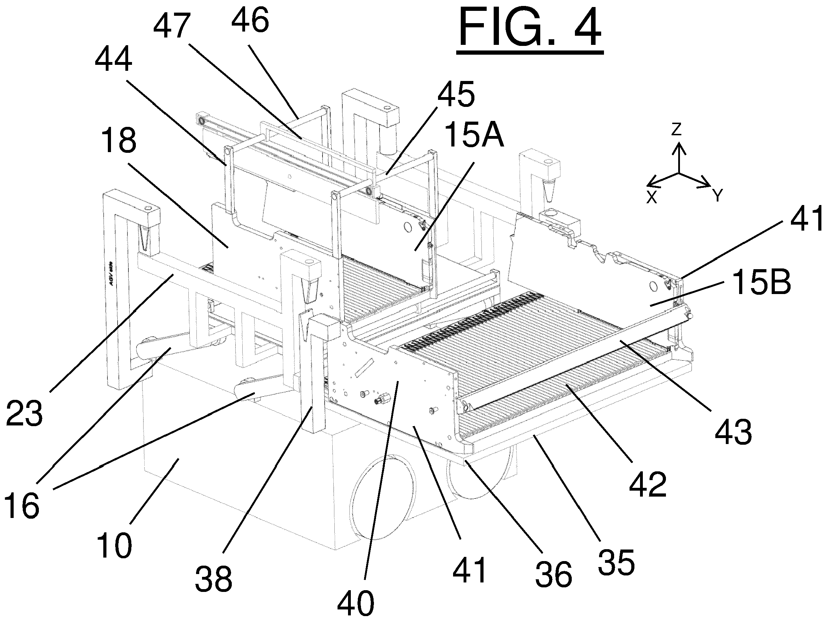

The transfer system also includes an item moving unit, here a feeder moving unit, which is operative to move items, i.e. feeders, from the replenishment feeder storage unit 18 to a receptacle of a placement machine (not shown in FIG. 2). The feeder moving unit shown is a double-stage arm, which is known in the art per se and so need not be described in great detail here. However, briefly the feeder moving unit includes a paddle 25 adapted to abut an individual feeder 15, which paddle 25 is drivable for movement in a direction orthogonal to the front face, i.e. parallel to the Y axis, and thus impel a feeder 15 towards the machine in use, and optionally also away from the machine if the machine does not include a feeder eject mechanism. The paddle 25 is here mounted to a drive, such as a belt drive or, as shown in FIG. 2, a rack and pinion drive) of the feeder moving unit. In more detail, the paddle 25 is mounted to a lower rack 26 of a dual-rack which also includes an upper rack 27, with both these racks 26, 27 being mounted to an arm 28 via a pinion (not shown in FIG. 2), the arm 28 being drivably connected to a paddle actuator here in the form of a drivable belt 30. At least the paddle 25, and here the entire feeder moving unit, is also movable relative to the replenishment feeder storage unit 18 in a horizontal direction parallel to the front face, i.e. parallel to the X axis, so that in use it may abut against a selected feeder 15 within an array of feeders located within the replenishment feeder storage unit 18. Further details of the feeder moving unit will be described with reference to FIG. 4 below.

The table 17 is mounted within a storage frame 23 which has a lateral extent (i.e. along the Y axis) approximately equal to the width of the AGV 10. At the machine-side extent (i.e. that side at greater Y value) the storage frame 23 carries at least one machine-side positioning member 24, as shown there are two machine-side positioning members: 24A, located at the front end of the storage frame 23, and 24B which is located at the rear end of the storage unit. The machine-side positioning members 24A, 24B project downwardly from the storage frame 23. At the vehicle-side extent the storage frame 23 carries at least one vehicle-side positioning dock, here there are two vehicle-side positioning docks, a front vehicle-side positioning dock 31A, located at the front end of the storage frame 23, and a rear vehicle-side positioning dock 31B which is located at the rear end of the storage frame 23. The front and rear vehicle-side positioning docks 31A, 31B project upwardly from the storage frame 23 with respective upwardly directed openings. The form and function of these positioning members and docks will be described in more detail below.

A front upright frame member 32 and a rear upright frame member 33 are fixedly mounted to the chassis 12. Each of these upright frame members 33, 34 carries a downwardly projecting positioning member, with front upright frame member 32 carrying a front vehicle-side positioning member 34A (not visible in FIG. 2), and rear upright frame member 33 carrying a rear vehicle-side positioning member 34B. The front vehicle-side positioning dock 31A is dimensioned to snugly receive the front vehicle-side positioning member 34A, while the rear vehicle-side positioning dock 31B is dimensioned to snugly receive the rear vehicle-side positioning member 34B. With the transfer system 11 in the retracted configuration shown in FIG. 2, in which the replenishment feeder storage unit 18 is located at a first, relatively close location (in the Y direction) relative to the AGV 10, the front vehicle-side positioning member 34A engages within the front vehicle-side positioning dock 31A, while the rear vehicle-side positioning member 34B engages within the rear vehicle-side positioning dock 31B.

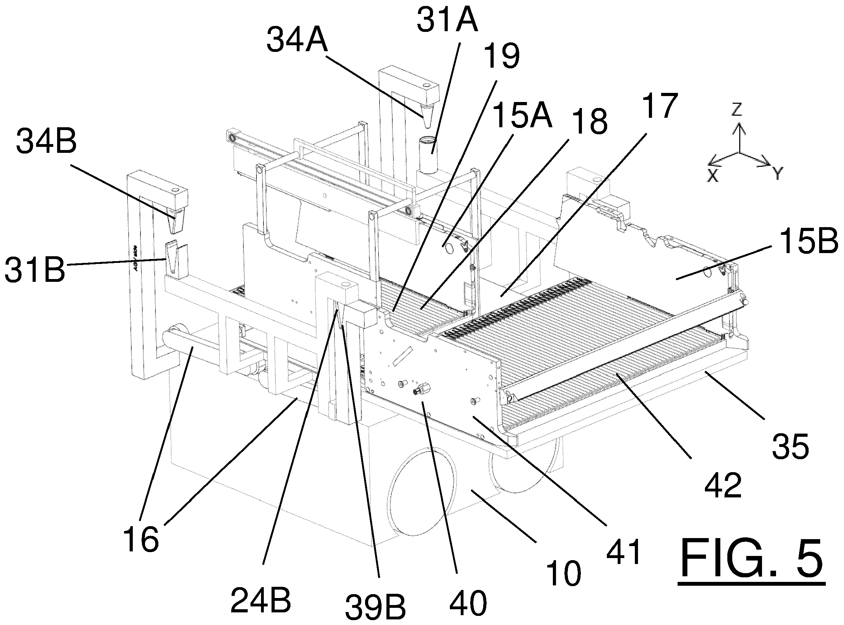

The engagement actuator is operative to move the replenishment feeder storage unit 18 between the retracted position as shown in FIG. 2, and a transfer position (as shown in FIG. 5 for example), in which the replenishment feeder storage unit 18 is located at a second, relatively far location (in the Y direction) relative to the AGV 10. In the retracted position, the transfer system 11 is substantially located within the horizontal spatial footprint of the AGV 10, so that the AGV 10 may travel safely. In the transfer position however, the front face of the replenishment feeder storage unit 18 of the transfer system 11 extends past the horizontal spatial footprint of the AGV 10, so that it may be positioned adjacent the machine receptacle to facilitate transfer of feeders between the receptacle and the replenishment feeder storage unit 18. In moving between the retracted and transfer positions, the engagement actuator causes the table 17, with the replenishment feeder storage unit 18 supported thereon, to move with a horizontal component of movement in a direction orthogonal to the front face, i.e. parallel to the Y axis, and thus towards or away from the machine in use. This is achieved by pivoting of the pivotable legs 16 to cause the storage unit 18 to move between the retracted position and the transfer position in a movement path comprising both vertical and horizontal movement components. As shown, this movement path will be arcuate due to the pivoting movement of the pivotable legs 16.

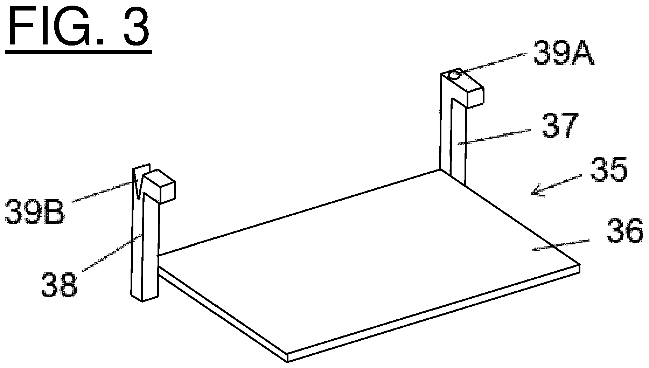

FIG. 3 schematically shows, in perspective view, a machine-side receptacle 35, with which a placement machine would be equipped. The receptacle 35 includes a substantially flat and horizontal base 36. In use, the base 36 would support a set-up feeder storage unit 40 (see FIG. 4 for example) adapted to receive a plurality of feeders 15. A front machine positioning frame 37 and a rear machine positioning frame 38 are provided at each end (i.e. separated in the X-direction) of the base 36. The front machine positioning frame 37 includes a front machine positioning dock 39A, while the rear machine positioning frame 38 includes a rear machine positioning dock 39B, each machine positioning dock 39A, 39B having an upwardly directed opening, and being dimensioned to respectively snugly receive the front machine-side positioning member 24A and the rear machine-side positioning member 24B.

FIGs. 4 to 9 schematically show, in perspective view, a transfer sequence for feeder replenishment using the AGV 10 and transfer system 11 of FIG. 2. Certain components of the transfer system 11 are omitted from these figures for clarity.

FIG. 4 schematically shows the AGV 10 which has positioned itself next to a placement machine, so that the storage frame 23 approximately aligns with the receptacle 35, subject to inherent AGV positional accuracy. The transfer system 11 maintains the replenishment feeder storage unit 18 in its retracted position as shown, during the positioning of the AGV 10 relative to the placement machine. A feeder 15A is shown located in the tray of the replenishment feeder storage unit 18, maintained in an upright configuration by engagement with feeder engagement tracks 19. Visible in FIG. 4 (but having been omitted from FIG. 2), is a positioning frame 44 mounted on the replenishment feeder storage unit 18, so that it is movable with the replenishment feeder storage unit 18, which positioning frame 44 supports the feeder moving unit. In more detail, the positioning frame 44 comprises a machine-side gantry 45 and a vehicle-side gantry 46 with a movable rail 47 supported therebetween. The movable rail 47 may be driven by a drive means (not shown) along a horizontal direction parallel to the X axis. For example, the machine-side gantry 45 and vehicle-side gantry 46 may each comprise worm screws which are rotatable by a drive means to drive the movable rail 47, though other possibilities will be apparent to those skilled in the art. The movable rail 47 carries the feeder moving unit suspended therefrom.

In FIG. 4 it can be seen that the base 36 of receptacle 35 supports a set-up feeder storage unit 40. In use, a set-up feeder storage unit 18 will remain within the placement machine during a placement operation. The set-up feeder storage unit 40 is generally similar to the replenishment feeder storage unit 18 in so far that it takes the form of a tray with sidewalls41, a plurality of feeder engagement tracks 42 at the bottom and a back-bar43 which aids the structural rigidity of the set-up feeder storage unit 40. A feeder 15B is shown engaged with one of these feeder engagement tracks 42. It should be noted that in the retracted position shown in FIG. 4, the replenishment feeder storage unit 18 is slightly higher (i.e. at a greater Z value) than the set-up feeder storage unit 40.

Once the AGV 10 is positioned proximate the placement machine as shown in FIG. 4, the engagement actuator is caused to operate to move the replenishment feeder storage unit 18 away from its retracted position and towards the transfer position (see FIG. 5). This is achieved by rotating the pivotable legs 16 towards the placement machine, which causes the table 17 and hence the replenishment feeder storage unit 18 to move in an arcuate path, so that the front vehicle-side positioning dock 31A and the 31B rear vehicle-side positioning dock 31B are lowered out of engagement with the front vehicle-side positioning member 34A and the rear vehicle-side positioning member 34B respectively, and the replenishment feeder storage unit 18 is moved towards the receptacle 35, both horizontally (i.e. in the positive Y direction) and vertically (i.e. in the negative Z direction). It should be noted that this horizontal travel is not prevented by the engagement of the front and rear vehicle-side positioning members 34A, 34B with their respective front and rear vehicle-side positioning docks 31A, 31B due to the sloping surfaces of the respective positioning members and docks.

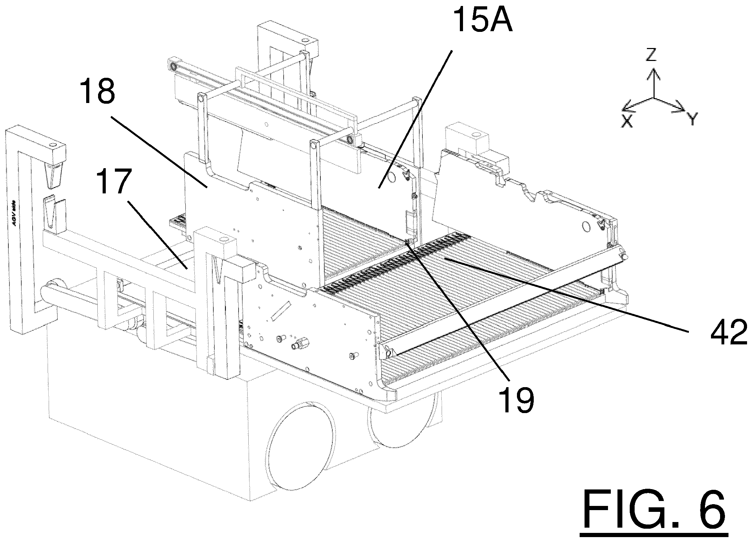

FIG. 5 schematically shows the transfer system with the replenishment feeder storage unit 18 in its transfer position, the pivotable legs 16 having been rotated to their maximum extent. The front machine-side positioning member 24A (not visible in FIG. 5) and rear machine-side positioning member 24B are fully lowered into engagement with the front machine positioning dock 39A (not visible in FIG. 6) and the rear machine positioning dock 39B respectively. The replenishment feeder storage unit 18 is not rigidly connected to the AGV 10, and therefore there is some "play" or tolerance in its positioning, so that the engagement between the machine-side positioning members and machine positioning docks impels the replenishment feeder storage unit 18 into a desired alignment, ensuring the correct relative positioning of the replenishment feeder storage unit 18 and set-up feeder storage unit 40, in both horizontal and vertical planes, so that a transfer of feeders between the two feeder storage units is possible.

With the replenishment feeder storage unit 18 in its transfer position, it is at the same height as the set-up feeder storage unit 40, i.e. the feeder engagement tracks 19 and 42 are at the same height. The replenishment feeder storage unit 18 and set-up feeder storage unit 40 are also close enough in the Y direction to permit a feeder to be transferred from one to the other. In addition, the table 17 aligns with the receptacle 35 in the X direction.

As schematically shown in FIG. 6, the replenishment feeder storage unit 18 is then moved relative to the table 17 along the X axis by the linear actuation mechanism so that a particular feeder engagement track 19, with its full feeder 15B, is aligned to a particular empty feeder engagement track 42 as required for operation of the placement machine.

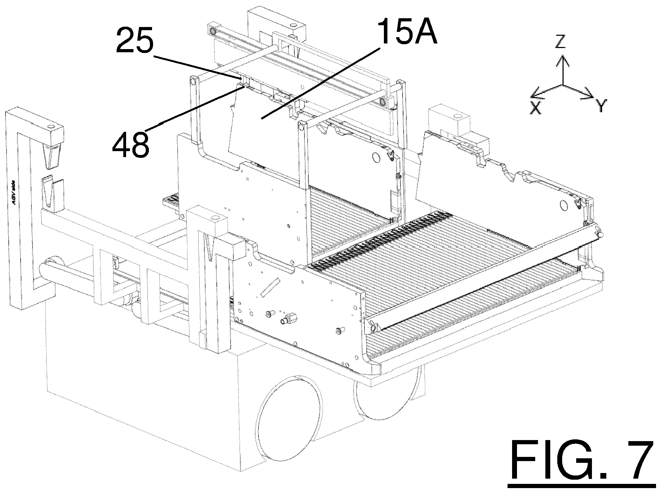

Then, as schematically shown in FIG. 7, the feeder moving unit is driven along the X axis until the paddle 25 is directly behind (i.e. at the same position along the X axis but at lower Y value) an engagement surface 48 of the feeder 15B. As shown, the engagement surface 48 is located on a projecting nub projecting from the top edge of the feeder 15B.

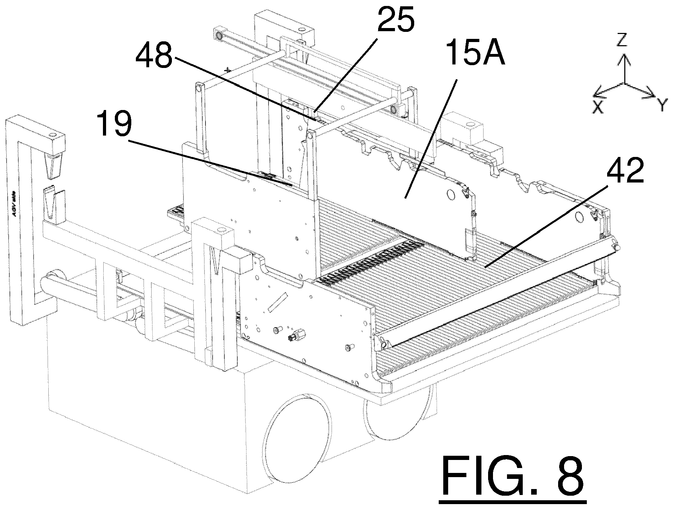

Then, as schematically shown in FIG. 8, the paddle 25 is moved towards the machine, i.e. in the positive Y direction. The paddle 25 abuts the engagement surface 48 and thereby pushes the feeder 15B along its feeder engagement track 19 and into another empty feeder engagement track 42.

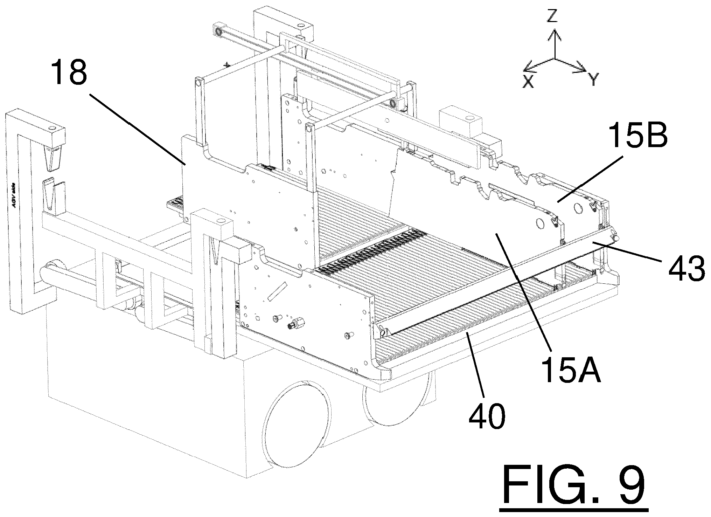

FIG. 9 schematically shows the feeder 15B fully inserted into the set-up feeder storage unit 40. The back-bar 43 acts as a hard-stop for the feeder 15B, preventing it from being pushed too far into the placement machine. It should be noted that due to the perspective and schematic nature of FIG. 9, a false impression that the feeder 15B overhangs the replenishment feeder storage unit 18 may be given - this is however not the case, and there is no risk of collision between the feeder 15B and the replenishment feeder storage unit 18.

In the above-described sequence, a full feeder 15A is shown being transferred to the set-up feeder storage unit 40. An empty or near empty feeder 15B may then optionally be transferred to the replenishment feeder storage unit 18. This is achieved by aligning the replenishment feeder storage unit 18 relative to the set-up feeder storage unit 40 so that an empty feeder engagement track 19 aligns to the empty feeder 15B, then causing the feeder moving unit to pull the feeder 15B, using the paddle 25, into that feeder engagement track 19.

In alternative embodiments, and depending on the particular feeder set-up, an empty or near-empty feeder 15B may first be transferred to an empty feeder engagement track 19, then the replenishment feeder storage unit 18 may subsequently be moved by the linear actuation mechanism until a full feeder 15A is brought into alignment with the now empty feeder engagement track 40, and the full feeder 15A transferred thereto.

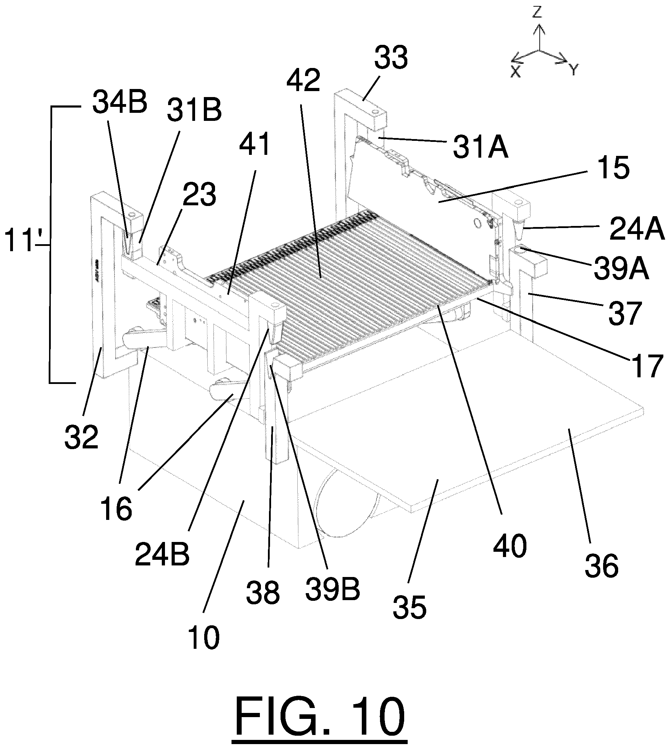

FIGs. 10 to 12 schematically show, in perspective view, a transfer sequence for a set-up change using the AGV 10 and a transfer system 11', which has many parts in common with the transfer system 11 of FIG. 2. Certain components of the transfer system 11 are omitted from these figures for clarity.

As shown in FIG. 10, the transfer system 11' comprises the same components as transfer system 11, except that the replenishment feeder storage unit 18 is replaced by a set-up feeder storage unit 40, similar to that shown in FIG. 4, having set-up feeder storage unit sidewalls 41 (only one being visible in FIG. 10) and feeder engagement tracks 42, located on table 17. For illustration, a single feeder 15 is shown located in an upright configuration in a respective feeder engagement track 42; in typical use a plurality of feeder engagement tracks 42, possible all of them, would be provided with respective feeders.

In FIG. 10, the AGV 10 has positioned itself next to a placement machine, so that the storage frame 23 approximately aligns with an empty receptacle 35, subject to inherent AGV positional accuracy. The transfer system 11' maintains the set-up feeder storage unit 40 in its retracted position as shown, during the positioning of the AGV 10 relative to the placement machine. In this retracted position, rear vehicle-side positioning member 34B engages with rear vehicle-side positioning dock 31B and front vehicle-side positioning member 34A (not visible in FIG. 10) engages with front vehicle-side positioning dock 31A.

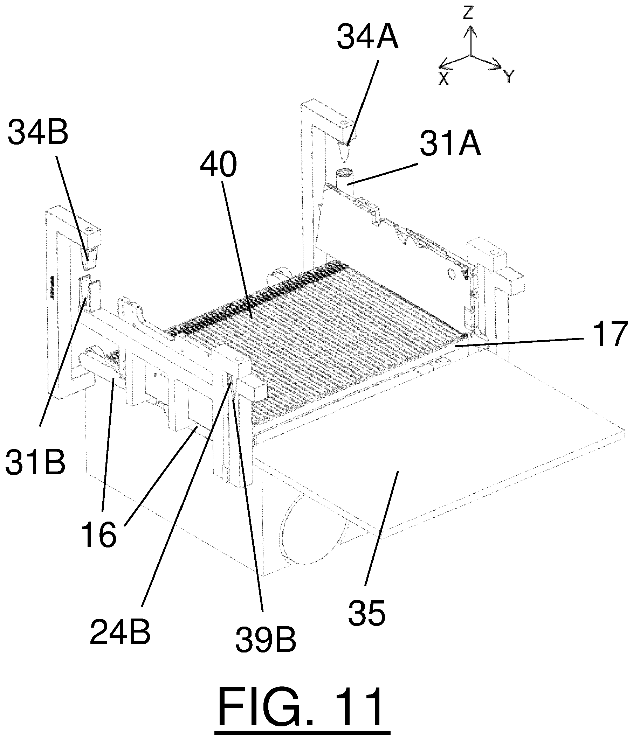

In FIG. 11, the set-up feeder storage unit 40 is shown having moved into its transfer position by rotating pivotable legs 16 towards the placement machine, which causes the table 17 and hence the set-up feeder storage unit 40 to move in an arcuate path, so that the front vehicle-side positioning dock 31A and the rear vehicle-side positioning dock 31B are lowered out of engagement with the front vehicle-side positioning member 34A and the rear vehicle-side positioning member 34B respectively, while the front machine-side positioning member 24A and the rear machine-side positioning member 24B are lowered into engagement with the front machine positioning dock 39A (not visible in FIG. 11) and the rear machine positioning dock 39B (not visible in FIG. 11) respectively. In this way, the set-up feeder storage unit 40 is moved towards the receptacle 35, both horizontally (i.e. in the positive Y direction) and vertically (i.e. in the negative Z direction).

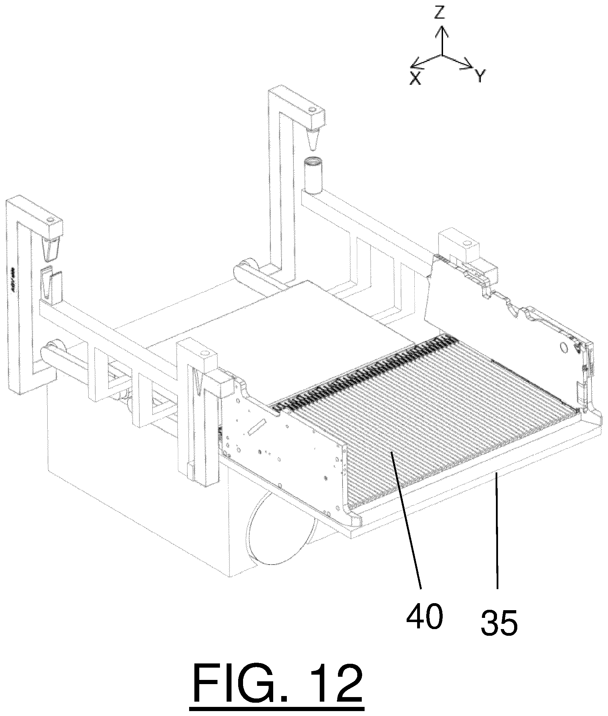

Then, as shown in FIG. 12, the set-up feeder storage unit 40 may be transferred into the receptacle 35. Conveniently, the transfer may be effected by a transfer device (not shown) provided at the placement machine which is operative to pull the set-up feeder storage unit 40 into the receptacle 35. Such transfer devices are known in the art per se to assist with set-up changes, and therefore are not described in more detail here. Alternatively, a transfer device may be provided in transfer system 11' to push the set-up feeder storage unit 40 into the receptacle 35. In this case, such a transfer device may be similar to the feeder moving unit described previously. Indeed, in some embodiments the feeder moving unit itself may be configured to provide this additional functionality.

The above-described embodiments are exemplary only, and other possibilities and alternatives within the scope of the invention will be apparent to those skilled in the art. For example, in the embodiments described above, the placement machine is provided with an integral docking port. However, a benefit of the present invention is that a docking port may alternatively be retrofitted to a placement machine. In such a scenario, a frame comprising the docking port may be located adjacent the side of a placement machine. The frame could for example be attachable to or mountable on the placement machine. Alternatively, the frame could be mounted on the floor next to and separate from the placement machine and adjusted to the correct working height for the adjacent placement machine.

The transfer system 11' may be used to transfer individual feeders rather than an entire set-up feeder storage unit. In such a case, a feeder moving unit may be provided attached to the transfer system 11', for example connected between the front and rear upright frame members 32, 33, to selectively push a feeder into a set-up feeder storage unit located within the receptacle 35. As a further alternative, a feeder moving unit may be provided which is operative to simultaneously push a plurality of feeders, optionally all of the feeders, located in the transfer system 11' to the set-up feeder storage unit located within receptacle 35. In this way, a fast set-up change may be effected without transferring a set-up feeder storage unit. This may readily be achieved by providing a relatively wide paddle, which can simultaneously engage with all of the feeders.

The first described embodiment uses pivotable arms to effect movement of the storage frame, however, as long a separated movement axes are provided to create movement in both Y and Z directions, effectors other than arms may be used.

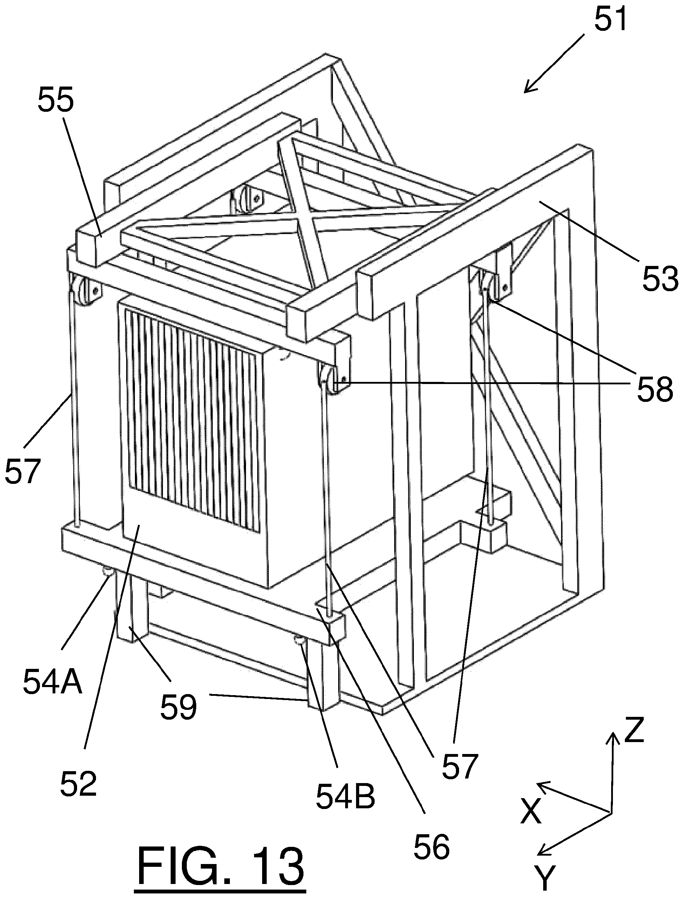

Another embodiment, in which an alternative form of engagement actuator is used, is schematically shown in perspective view from above in FIG. 13. In this embodiment, rather than using pivotable legs, the engagement actuator comprises a lifting mechanism for suspending a storage unit 52 (for example a replenishment feeder storage unit or a set-up feeder storage unit as previously described) from the transfer system 51 and moving the storage unit 52 vertically. In addition, the lifting mechanism is horizontally movable with respect to the vehicle in use. The combination of vertical and horizontal movements possible with this type of engagement actuator again permits the storage unit to be moved between a retracted position in which the storage unit 52 is located at a first, relatively close location relative to the vehicle, and a transfer position in which the storage unit 52 is located at a second, relatively far location relative to the vehicle and in which a machine-side positioning member 54A, 54B may engage with a machine-side positioning dock (not shown) located proximate the receptacle (not shown) to position the storage unit relative to the machine (not shown).

As shown in FIG. 13, the transfer system 51 is suitable for mounting onto an AGV (not shown) similarly to the previously-described embodiments. The transfer system 51 includes a rigid frame 53 which carries a lifting mechanism comprising a gantry 55, a table 56 suspended therefrom by cables 57 and associated pulleys 58. The gantry 55 is movable horizontally (i.e. parallel to the Y axis as shown) by a suitable horizontal actuator (not shown) of the engagement actuator, such as, for example a rack and pinion arrangement, linear drive etc., and the table 56 will move horizontally with the gantry 55. Actuation of the cables 57, for example by winding using a rotary actuator, causes the suspended table 56, and any storage unit 52 supported thereon, to move vertically, i.e. parallel to the Z axis as shown. Depending from the underside of the table 56 is a pair of legs 59, which act to stabilize the table 56 while the storage unit 52 is in the retracted position, by resting on the platform (not shown) of the AGV. The table 56 also carries a front machine-side positioning member 54A and a rear machine-side positioning member 54B which both project downwardly from the underside of the table 56. These are used in a similar manner as described with respect to the previous embodiments, in that they may each engage with a respective machine-side positioning dock (not shown) located proximate the receptacle to position the storage unit 52 relative to the machine when it is in the transfer position. The machine-side positioning members 54A, 54B may - similarly to the previously-described embodiments - comprise one of the group consisting of a projection with at least one surface angled to the vertical direction to form a sloping surface and a recess with at least one surface angled to the vertical direction to form a sloping surface, so that when in the transfer position and engaged with respective machine-side positioning docks, the table 56, and hence storage unit 52 are impelled to a correct position relative to the machine to enable a replenishment or set-up change operation to be performed. Although not shown in FIG. 13, a feeder moving unit, similar to that described with respect to the previous embodiments, may also be provided attached to the lifting mechanism, to effect the replenishment or set-up change operation.

Advantageously, the weight supported by the AGV during docking of the table 56 to the machine may be monitored, for example by providing one or more sensors (not shown), such as strain gauges or torque sensors, associated with one or more cables 57, which sensors may provide the control system with data indicative of the strain in the respective cable 57, and hence the weight which is carried by the cable. Alternatively, the weight may be determined through monitoring of the current drawn by the or each rotary actuator driving the cables 57. The or each rotary actuator may be controlled in dependence on the monitored signals. In this way, the weight supported by the AGV, and thus the transfer of weight - which may considerable - from the AGV to the machine may be controlled so as to minimize potentially damaging 'jumps' in transferred weight. This smoothing of the transferred weight may further be improved by provided elastic members (not shown), such as springs, between the AGV platform and the transfer system 51 and/or in line with cables 57, or alternatively an addition active-controlled system between the AGV platform and the transfer system 51 may be provided to control the weight transfer.

As an extension to this, and if the number of available AGVs is sufficient, then the AGV may be permanently located beneath the table 56 next to the machine, so that it supports at least some of the weight of the table 56 during use (i.e. during a placement operation), with the weight supported being controlled through the sensing system outlined above.

It should be noted that the weight transfer control systems and methodology described above may equally be employed with the transfer system of the first embodiment, or indeed with other types of transfer systems within the scope of the present invention.

Although the invention has been described with particular reference to the transferring of feeders and / or cartridges to and from placement machines, the invention is equally applicable to the transfer of other items associated with SMT production lines. For example, the transfer system may be used to transfer printing screens or stencils to and from printing machines, including but not limited to printing screens or stencils held within a tensioning frame therefor.

While the invention has been described for use with an AGV, the transfer system may be provided on other types of vehicle, including trolleys.

The above described embodiments provide both horizontal and vertical components of movement for moving the storage unit between the retracted and transfer positions, however, in some situations vertical movement need not be required. For example, if it can be guaranteed that the vehicle, and hence the storage unit it is transporting, is at a suitable height, then only horizontal movement need be used to move the storage unit to the transfer position. In this case, purely horizontally-oriented engagement members need be provided at the machine and vehicle.

### Reference numerals used:

1-AGV
2 - Chassis
3 - Wheels
4 - Platform
10 - AGV
11, 11' - Transfer system
12 - Chassis
13 - Platform
14 - Wheels
15, 15A, 15B - Feeder
16 - Pivotable legs
17 -Table
18 - Replenishment feeder storage unit
19 - Feeder engagement tracks
20 - Sidewalls
21 - Worm screw
22 - Gears
23 - Storage frame
24A - Front machine-side positioning member
24B - Rear machine-side positioning member
25 - Paddle
26 - Lower rack
27 - Upper rack
28 - Arm
30 - Drivable belt
31A - Front vehicle-side positioning dock
31B - Rear vehicle-side positioning dock
32 - Front upright frame member
33 - Rear upright frame member
34A - Front vehicle-side positioning member
34B - Rear vehicle-side positioning member
35 - Receptacle
36 - Base
37 - Front machine positioning frame
38 - Rear machine positioning frame
39A - Front machine positioning dock
39B - Rear machine positioning dock
40 - Set-up feeder storage unit
41 - Set-up feeder storage unit sidewalls
42 - Feeder engagement tracks
43 - Back-bar
44 - Positioning frame
45 - Machine-side gantry
46 - Vehicle-side gantry
47 - Movable rail
48 - Engagement surface
49 - Bracket
51 - Transfer system
52 - Storage unit
53 - Frame
54A - Front machine-side positioning member
54B - Rear machine-side positioning member
55 - Gantry
56 -Table
57 - Cables
58 - Pulleys
59 - Legs

## Claims

1. A transfer system for transferring items between a vehicle and a receptacle of a machine, comprising:
an engagement actuator, and
a storage unit for storing at least one item in use, the storage unit being movably mounted on the vehicle in use, wherein the storage unit comprises a front face that is adapted to lie adjacent to the receptacle in use, and a machine-side positioning member,
and wherein the engagement actuator is operative to move the storage unit between a retracted position in which the storage unit is located at a first, relatively close location relative to the vehicle, and a transfer position in which the storage unit is located at a second, relatively far location relative to the vehicle and in which the machine-side positioning member may engage with a machine-side positioning dock located proximate the receptacle to position the storage unit relative to the machine.

2. The transfer system of claim 1, wherein the machine-side positioning member comprises one of the group consisting of a projection with at least one surface angled to the vertical direction to form a sloping surface and a recess with at least one surface angled to the vertical direction to form a sloping surface.

3. The transfer system of either of claims 1 and 2, comprising a vehicle-side positioning dock mounted to the vehicle in use, and
wherein the storage unit comprises a vehicle-side positioning member,
wherein in the retracted position, the vehicle-side positioning member engages with the vehicle-side positioning dock to position the storage unit relative to the vehicle.

4. The transfer system of claim 3, wherein one of the vehicle-side positioning member and vehicle-side positioning dock comprises a projection with at least one surface angled to the vertical direction to form a sloping surface, and the other of the vehicle-side positioning member and vehicle-side positioning dock comprises a recess dimensioned to snugly receive the projection; optionally one of the vehicle-side positioning member and vehicle-side positioning dock comprises a cone and the other of the vehicle-side positioning member and vehicle-side positioning dock comprises a conical recess; optionally one of the vehicle-side positioning member and vehicle-side positioning dock comprises a linear ridge and the other of the vehicle-side positioning member and vehicle-side positioning dock comprises a linear recess.

5. The transfer system of any preceding claim, wherein the engagement actuator is actuable to cause the storage unit to move with a horizontal component of movement in a direction orthogonal to the front face, and thus towards or away from the machine in use.

6. The transfer system of claim 5, wherein the engagement actuator is actuable to cause the storage unit to move with a vertical component of movement.

7. The transfer system of claim 6, wherein the engagement actuator comprises pivotable legs linking the storage unit to the vehicle, the arrangement being such that pivoting of the pivotable legs causes the storage unit to move between the retracted position and the transfer position in a movement path comprising both vertical and horizontal movement components.

8. The transfer system of claim 6, wherein the engagement actuator comprises a lifting mechanism for suspending the storage unit from the transfer system and moving the storage unit vertically; optionally the lifting mechanism comprises cables for suspending the storage unit; optionally the cables are windable for moving the suspended storage unit vertically; optionally the lifting mechanism is horizontally movable with respect to the vehicle in use.

9. The transfer system of any preceding claim, wherein the storage unit comprises a feeder container which is movable relative to the engagement actuator in a horizontal direction parallel to the front face, the tray being adapted for storing the at least one item in use.

10. The transfer system of any preceding claim, wherein the storage unit is adapted to retain a tray, the tray being adapted to store the at least one item, the tray being movable relative to the storage unit in a horizontal direction orthogonal to the front face so that the tray may be transferred to the receptacle when the storage unit is in the transfer position.

11. The transfer system of any preceding claim, comprising an item moving unit comprising a movable paddle adapted to abut an individual item and a paddle actuator operative to move the paddle in a direction orthogonal to the front face, and thus impel an item towards the machine in use; optionally the paddle is movable relative to the storage unit in a horizontal direction parallel to the front face so that in use it may abut against a selected item within an array of items located within the storage unit.

12. The transfer system of any preceding claim, wherein the item comprises a feeder or cassette and the machine comprises a placement machine; or the item comprises a printing screen or stencil, and the machine comprises a printing machine.

13. The transfer system of any preceding claim, comprising means for monitoring the weight supported by the vehicle, and means for controlling the weight supported by the vehicle as the storage unit moves from the retracted position to the transfer position.

14. An automatic-guided vehicle comprising the transfer system of any preceding claim.

15. A method of transferring an item from a vehicle to a receptacle of a machine, comprising the steps of:
i) providing a machine-side positioning dock located proximate the receptacle,
ii) providing a vehicle with the transfer system of any of claims 1 to 16, with at least one item located within the storage unit,
iii) moving the vehicle proximate the machine, with the storage unit in its retracted position,
iv) moving the storage unit to its transfer position so that the machine-side positioning member engages with the machine-side positioning dock, and
v) transferring the item from the storage unit to the receptacle.
